# EUROPÄISCHE PATENTSCHRIFT

(11) **EP 2 219 059 B1**
(45) Veröffentlichungstag und Bekanntmachung des Hinweises auf die Patenterteilung: **31.08.2016**
(21) Anmeldenummer: 10153416.2
(22) Anmeldetag: 12.02.2010
(51) Int. Cl.: G02B 6/42, G02B 6/136

(54) **Verfahren zur Herstellung einer elektro-optischen Leiterplatte mit Lichtwellenleiterstrukturen**
Method for producing an electro-optical printed circuit board with optical waveguide structures
Méthode de fabrication d'une carte de circuit imprimé électro-optique ayant des structures de guides d'onde optique

(30) Priorität: 17.02.2009 CH 2512009; 30.09.2009 CH 15082009
(43) Veröffentlichungstag der Anmeldung: 18.08.2010
(73) Patentinhaber: vario-optics ag, 9410 Heiden (CH)
(72) Erfinder: Halter, Markus, 9444 Diepoldsau (CH); Betschon, Felix, 9011 St. Gallen (CH)
(74) Vertreter: Falk, Urs

(56) Entgegenhaltungen:
- EP-A1- 1 972 975
- EP-A1- 2 000 837

## Beschreibung

### Technisches Gebiet

Die vorliegende Erfindung beschreibt ein Verfahren zur Herstellung einer elektro-optischen Leiterplatte mit Lichtwellenleiterstrukturen.

### Stand der Technik

Die elektro-optische Leiterplattentechnologie betrifft die Herstellung von Leiterplatten, die elektronische, elektro-optische und optische Komponenten miteinander verbinden. Sie enthalten einerseits elektrische Leiterbahnen und andererseits Lichtwellenleiterstrukturen.

Lichtwellenleiterstrukturen bestehen aus einer Mehrzahl von transparenten Schichten, in der Regel drei Schichten, aus UV-härtenden Polymermaterialien mit unterschiedlichen Brechungsindices. Aufgrund der Transparenz können die Lichtwellenleiterstrukturen bei der Montage der Bauteile nicht mittels Bilderkennungssystemen detektiert werden. Eine präzise Ausrichtung von elektro-optischen Komponenten wie LED's, Laserquellen, Photodioden oder anderen Elementen wie optischen Fasern, etc. anhand der Lichtwellenleiterstrukturen und relativ zu den Lichtwellenleiterstrukturen ist aufgrund der Transparenz nicht möglich. Die präzise Ausrichtung der einzelnen Komponenten relativ zueinander ist aber zwingend erforderlich.

Aus der EP 2000837 ist ein Verfahren zur Herstellung von Lichtwellenleiterstrukturen bekannt, die eine Unterschicht (under-cladding layer), eine Kernschicht (core layer) und eine Mantelschicht (over-cladding layer) umfassen. Diese Schichten werden schrittweise auf ein Substrat, beispielsweise eine Glasplatte, aufgebracht und jeweils mithilfe einer Belichtungsmaske strukturiert. Im ersten Schritt wird die Unterschicht auf das Substrat aufgebracht. Anschliessend findet mit Belichtung durch eine erste Belichtungsmaske hindurch und Entfernung der nicht belichteten Abschnitte eine Strukturierung der Unterschicht statt, wobei auch freiliegende Referenzmarken aus dem Material der Unterschicht erzeugt werden. Weil die Unterschicht transparent ist, sind diese Referenzmarken nicht sichtbar. Um sie sichtbar zu machen, werden sie in einem nächsten Schritt mit einem Metallfilm überdeckt. Dazu müssen die übrigen Bereiche der Unterschicht abgedeckt und dann die Referenzmarken mit Metall beschichtet werden. Dies erfolgt in einer Vakuumkammer durch Aufdampfen oder Sputtering. Die Referenzmarken werden bei der weiteren Herstellung der Lichtwellenleiterstrukturen benutzt, um die Belichtungsmasken zur Strukturierung der Kernschicht und der Mantelschicht auszurichten.

Aus der EP 1120672 ist ein Verfahren zur Herstellung von passiven optischen Komponenten mit Lichtwellenleiterstrukturen bekannt, die mit aktiven optischen Komponenten zu einem optischen Element kombiniert werden. Eine Unterschicht, eine Kernschicht, eine Metallschicht und eine Mantelschicht werden schrittweise auf ein Substrat aus Silizium aufgebracht und jeweils mithilfe von Belichtungsmasken strukturiert. Die Kernschicht und die Metallschicht werden gemeinsam mit Hilfe einer Belichtungsmaske und einer entsprechenden Belichtung und Entfernung der nicht belichteten Abschnitte strukturiert. Anschliessend wird die Metallschicht auf denjenigen Teilen der strukturierten Kernschicht entfernt, die die Lichtwellenleiterstrukturen bilden, während andere Teile der strukturierten Kernschicht mit der Metallschicht nicht entfernt werden und somit sichtbare Justierungsmarken bilden. Die Justierungsmarken werden später benutzt, um diese passive Komponente mit aktiven optischen Elementen zu verbinden, die eine den Justierungsmarken entsprechende komplementäre Struktur aufweisen.

Eine Lichtwellenleiterstruktur, bei der die Kernschicht und metallisierte Referenzmarken gleichzeitig gebildet werden, ist auch aus der US 6553171 bekannt.

### Kurze Darstellung der Erfindung

Die vorliegende Erfindung hat sich zur Aufgabe gestellt, ein Verfahren zur Herstellung einer elektro-optischen Leiterplatte mit Lichtwellenleiterstrukturen zu schaffen, welches eine hochpräzise Montage von elektro-optischen Bauteilen in Bezug zu den Lichtwellenleiterstrukturen ermöglicht, ohne dass die Bauteile bei der Montage aktiv justiert werden müssen.

Diese Aufgabe wird durch das Verfahren gemäss Patentanspruch 1 gelöst. Vorteilhafte Ausführungen und Weiterentwicklungen sind in den abhängigen Ansprüchen definiert.

Das Licht bewegt sich entlang der durch die Strukturen der Kernschicht der Lichtwellenleiterstrukturen definierten Bahnen. Das erfindungsgemässe Verfahren basiert auf der Idee, die transparente Kernschicht sowohl auf die transparente Unterschicht als auch auf unstrukturierte, nicht-transparente Flächen, d.h. gut sichtbare Flächen, aufzutragen und nicht nur auf der Unterschicht, sondern auch auf den nicht-transparenten Flächen zu strukturieren, und anschliessend diese Struktur in die nicht-transparenten Flächen zu übertragen, beispielsweise durch Ätzen. Auf diese Weise werden die anfangs unstrukturierten, nicht-transparenten Flächen zu sichtbaren Referenzmarken, die die Information über die tatsächliche Lage der strukturierten Kernschicht der Lichtwellenleiterstrukturen und somit über die Lage der Bahnen, die das Licht leiten, enthalten.

Alternativ ist es möglich, auf den unstrukturierten, nicht-transparenten Flächen anstelle von Material der Kernschicht einen Fotolack aufzutragen, wobei die Strukturen in der Kernschicht und im Fotolack gleichzeitig durch Belichten durch die gleiche Belichtungsmaske hindurch erzeugt werden.

Die Referenzmarken können verwendet werden, um durch mechanische Bearbeitung oder Laserbearbeitung Vertiefungen und/oder Löcher in der Leiterplatte anzubringen, die dann hochpräzise zur Kernschicht ausgerichtet sind.

Das erfindungsgemässe Verfahren wird anhand der Zeichnung im Detail erläutert. Die Figuren sind schematisch und nicht massstäblich gezeichnet. Die Figuren zeigen Momentaufnahmen während des Herstellungsverfahrens einer elektro-optischen Leiterplatte.

### Kurze Beschreibung der Zeichnungen

- Fig. 1a: zeigt einen Schnitt durch ein Substrat, auf dem eine unstrukturierte, nicht-transparente Fläche aufgebracht ist,
- Fig. 1b: zeigt einen Schnitt durch das Substrat mit aufgetragener Unterschicht während des UV-Belichtungsvorganges mit einer ersten Belichtungsmaske,
- Fig. 1c: zeigt einen Schnitt durch das Substrat, nachdem das unbelichtete Material der Unterschicht entfernt wurde,
- Fig. 1d: zeigt einen Schnitt durch das Substrat mit aufgetragener Kernschicht während des UV-Belichtungsvorganges mit einer zweiten Belichtungsmaske,
- Fig. 1e: zeigt einen Schnitt durch das Substrat, nachdem die Unterschicht mit der Kernschicht bedeckt und die nicht-transparente Fläche mit einem UV-härtenden Fotolack bedeckt wurde,
- Fig. 1f: zeigt einen Schnitt durch das Substrat, nachdem das unbelichtete Material der Kernschicht entfernt wurde,
- Fig. 1g: zeigt einen Schnitt durch das Substrat mit aufgetragener Mantelschicht während des UV-Belichtungsvorganges mit einer dritten Belichtungsmaske,
- Fig. 1h: zeigt einen Schnitt durch das Substrat, nachdem das unbelichtete Material der Mantelschicht entfernt wurde,
- Fig. 1i: zeigt einen Schnitt durch das Substrat, nachdem die auf der nicht-transparenten Fläche verbliebene Struktur der Kernschicht in die nicht-transparente Fläche übertragen wurde,
- Fig. 1j: zeigt einen Schnitt durch das Substrat, nachdem ein das Substrat und die nicht-transparente Fläche querendes Loch angebracht wurde,
- Fig. 1k: zeigt eine auf dem Substrat montierte elektro-optische Komponente,
- Fig. 2a: zeigt eine Aufsicht auf eine Fläche in Form eines Kreuzes,
- Fig. 2b: zeigt eine Aufsicht auf eine quadratische Fläche mit zwei auf einer Diagonalen der Fläche angeordneten Löchern,
- Fig. 2c: zeigt eine Aufsicht auf eine quadratische Fläche mit einem zentralen Loch,
- Fig. 3a: zeigt eine perspektivische Ansicht einer elektro-optischen Leiterplatte mit angekoppeltem Spiegelmodul,
- Fig. 3b: zeigt eine perspektivische Ansicht einer elektro-optischen Leiterplatte mit angekoppelter Diode,
- Fig. 3c: zeigt eine perspektivische Ansicht einer elektro-optischen Leiterplatte mit Teilen angekoppelter Glasfasern,
- Fig. 4: zeigt eine Aufsicht auf mehrere voneinander beabstandete nicht-transparente Flächen, und
- Fig. 5: zeigt einen Schnitt durch das Substrat mit teilweise freigelegter Unterschicht.

### Detaillierte Beschreibung

Eine elektro-optische Leiterplatte mit Lichtwellenleiterstrukturen besteht aus einem Substrat 1, auf dem einerseits metallische Strukturen, insbesondere Leiterbahnen, für die elektrische Verbindung von elektronischen und elektro-optischen Bauteilen und andererseits Lichtwellenleiterstrukturen angeordnet sind. Das Substrat 1 besteht zum Beispiel aus FR4, Polyimid oder einem anderen geeigneten Material.

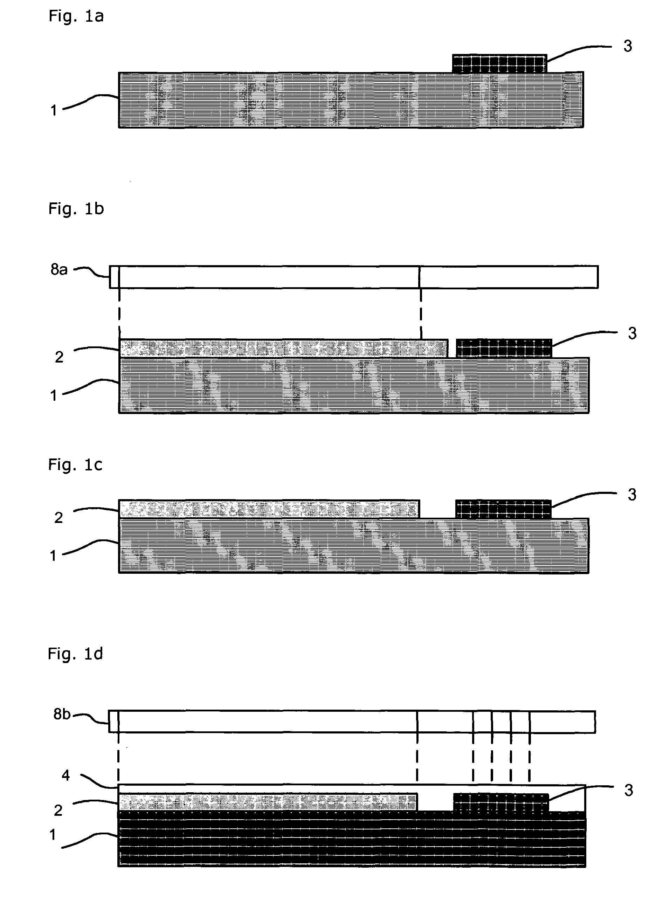

Das erfindungsgemässe Verfahren zur Herstellung einer elektro-optischen Leiterplatte mit Lichtwellenleiterstrukturen umfasst die Verfahrensschritte A bis F und fakultativ den Verfahrenschritt G, die nachfolgend im Detail anhand der Fig. 1a bis 1k erläutert werden:
A) Bilden von nicht-transparenten Flächen 3 auf dem Substrat 1. Bei diesem Schritt wird ein nicht-transparentes Material derart auf das Substrat 1 aufgetragen und gegebenenfalls strukturiert, dass auf dem Substrat 1 nicht-transparente Flächen 3 gebildet werden. Der Zustand nach diesem Schritt ist in der Fig. 1a gezeigt.

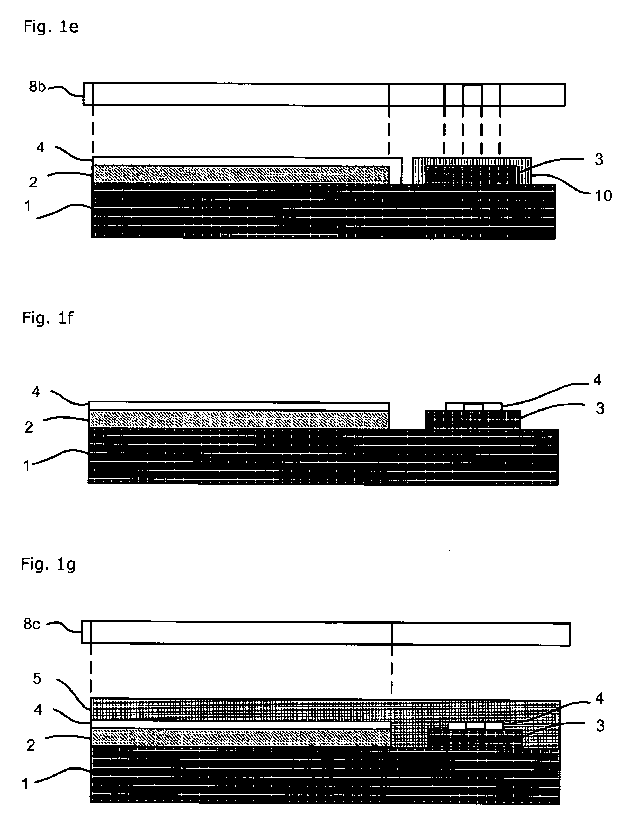

Die Lichtwellenleiterstrukturen bestehen aus drei Schichten, nämlich einer Unterschicht 2, einer Kernschicht 4 und einer Mantelschicht 5. Die Unterschicht 2 und die Kernschicht 4 sind optisch transparent. Die Mantelschicht 5 ist meistens ebenfalls transparent. Die Wellenleitereigenschaften ergeben sich dadurch, dass der Brechungsindex der Kernschicht 4 sich vom Brechungsindex der Unterschicht 2 und der Mantelschicht 5 unterscheidet. Die Strukturen dieser drei Schichten werden durch herkömmliche fotolithografische Verfahrensschritte gebildet, nämlich durch Belichten mittels elektromagnetischer Strahlung durch je eine Belichtungsmaske 8a (Fig. 1b), 8b (Fig. 1d) und 8c (Fig. 1g) hindurch und anschliessendes Entfernen der nicht belichteten Gebiete. Der Begriff "elektromagnetische Strahlung" ist innerhalb der ganzen Beschreibung derart zu verstehen, dass die elektromagnetische Strahlung insbesondere UV Licht sein kann. Als Belichtungsmasken 8a, 8b und 8c können herkömmliche Belichtungsmasken verwendet werden, welche in der Leiterplatten- und Chipherstellung gebräuchlich sind. Typischerweise handelt es sich um chrombeschichtete Glasplatten, welche entsprechend strukturiert sind. Die Unterschicht 2 und die Mantelschicht 5 sind in der Regel Schichten, die eine gewisse Fläche einnehmen, und nur die Kernschicht 4 ist innerhalb dieser Fläche strukturiert, um einzelne Lichtwellenleiter zu bilden. Die Belichtungsmasken 8a, 8b und 8c werden mithilfe von speziellen (nicht dargestellten), auf dem Substrat 1 angebrachten Referenzmarken, sogenannten "Fiducials" bezüglich des Substrats 1 ausgerichtet.

Die nicht-transparenten Flächen 3, die auch als nicht-transparente Felder bezeichnet werden können, haben keine besondere Form oder Struktur, sie sind beispielsweise rechteckförmig oder quadratisch und müssen optisch sichtbar sein, d.h. eine grosse Opazität aufweisen. Die nicht-transparenten Flächen 3 werden mit Vorteil aus Metall gebildet, beispielsweise aus einer dünnen Kupferschicht, deren Schichtdicke typischerweise im Bereich von etwa 10 µm bis 100 µm liegt, jedoch auch größere Werte von bis zu 210 µm oder noch mehr annehmen kann. Die Leiterplatte enthält mindestens eine Lage mit elektrischen Verbindungsleitungen, die in der Regel aus Kupfer sind. Die nicht-transparenten Flächen 3 werden mit Vorteil gleichzeitig mit diesen Verbindungsleitungen hergestellt.

Mit den nächsten Schritten B, C1 oder C2, D und E werden die Lichtwellenleiterstrukturen hergestellt.
B) Aufbringen auf das Substrat 1 und Strukturieren der Unterschicht 2 derart, dass die Unterschicht 2 die nicht-transparenten Flächen 3 nicht bedeckt.

Die Unterschicht 2 besteht aus einem ersten Polymer, das durch Belichten mit UV Licht ausgehärtet werden kann. Das Aufbringen und Strukturieren des Polymers erfolgt in drei Teilschritten:
1) Das Polymer wird auf das Substrat aufgebracht, beispielsweise durch Rakeln, Spincoating, Inkjet oder ein anderes bekanntes Verfahren, und bildet dann eine grossflächige, noch unstrukturierte Polymerschicht. Diese Verfahren erlauben es, das Polymer entweder auf das ganze Substrat oder nur lokal an gewissen Stellen auf dem Substrat aufzutragen.
2) Vorbestimmte Regionen dieser Polymerschicht werden mittels UV Licht ausgehärtet. Dabei wird zuerst eine erste Belichtungsmaske 8a an den Fiducials bezüglich des Substrats 1 ausgerichtet. Anschliessend wird die Polymerschicht durch die erste Belichtungsmaske 8a hindurch mit UV Licht belichtet. Die belichteten Regionen härten während der Belichtung aus, die nicht belichteten Regionen härten nicht aus. Die Belichtungsmaske 8a definiert somit die Lage der auszuhärtenden Regionen in Bezug auf die Fiducials. Dieser Zustand ist in der Fig. 1b gezeigt.
3) Das nicht belichtete erste Polymer wird entfernt, zum Beispiel durch Wegwaschen, so dass nur die ausgehärteten Regionen der Polymerschicht als strukturierte Unterschicht 2 auf dem Substrat 1 verbleiben. Dieser Zustand ist in der Fig. 1c gezeigt.

Die vorbestimmten Regionen befinden sich neben den nicht-transparenten Flächen 3, so dass die strukturierte Unterschicht 2 und die nicht-transparenten Flächen 3 nicht überlappen.

Es folgt nun entweder der Schritt C1 oder alternativ der Schritt C2:
C1) Aufbringen der Kernschicht 4, wobei die Kernschicht 4 sowohl die strukturierte Unterschicht 2 als auch die nicht-transparenten Flächen 3 bedeckt.
C2) Aufbringen der Kernschicht 4, wobei die Kernschicht 4 die nicht-transparenten Flächen 3 nicht bedeckt, und Aufbringen einer Fotolackschicht 10, die nur die nicht-transparenten Flächen 3, nicht aber die Kernschicht 4 bedeckt.

Die Kernschicht 4 besteht aus einem zweiten Polymer, das durch Belichten mit UV Licht ausgehärtet werden kann. Versuche haben gezeigt, dass die verwendeten Polymere im ausgehärteten Zustand ausgezeichnete Haftungswerte auf Kupfer aufweisen. In diesem Fall gelangt der Verfahrenschritt C1 zur Anwendung. Falls aus anwendungstechnischen Gründen ein anderes Material verwendet werden muss, welches auf Kupfer bzw. dem vorgesehenen Metall schlecht haftet, kann auch partiell ein herkömmlicher, UV-härtender Fotolack auf die unstrukturierten Flächen 3 aufgetragen werden. In diesem Fall gelangt der Verfahrenschritt C2 zur Anwendung. Die folgenden Schritte sind in beiden Fällen C1 und C2 die gleichen.
D) Strukturieren der Kernschicht 4 und gegebenenfalls der Fotolackschicht 10 durch Belichten mit UV Licht durch eine zweite Belichtungsmaske 8b hindurch und anschliessendes Entfernen der nicht belichteten Teile der Kernschicht 4 und gegebenenfalls der nicht belichteten Teile der Fotolackschicht 10, wobei auf den nicht-transparenten Flächen 3 strukturierte Gebiete aus der Kernschicht 4 bzw. aus Fotolack mit mindestens einer Öffnung oder Ausnehmung zurückbleiben.

Der Verfahrenschritt D wird im Prinzip mit ähnlichen Teilschritten wie die Teilschritte 2 und 3 beim Verfahrenschritt B durchgeführt. Die Belichtungsmaske 8b wird an den Fiducials auf dem Substrat 1 ausgerichtet. Die Fig. 1d zeigt den Zustand während der Belichtung mit UV Licht, wenn die Herstellung der Leiterplatte mit dem Schritt C1 erfolgt. Die Fig. 1e zeigt den Zustand während der Belichtung mit UV Licht, wenn die Herstellung der Leiterplatte mit dem Schritt C2 erfolgt.

Die Fig. 1f zeigt den Zustand nach dem Entfernen der nicht belichteten Teile der Kernschicht 4, wenn die Herstellung der Leiterplatte mit dem Schritt C1 erfolgte. Der Zustand nach dem Verfahrenschritt D ist fast der gleiche, wenn die Herstellung der Leiterplatte mit dem Schritt C2 erfolgte, bis auf den Unterschied, dass die nicht-transparenten Flächen 3 im einen Fall mit dem Polymer der Kernschicht 4 und im andern Fall mit Fotolack beschichtet sind.
E) Aufbringen und Strukturieren der Mantelschicht 5 derart, dass die Mantelschicht 5 die nicht-transparenten Flächen 3 nicht bedeckt.

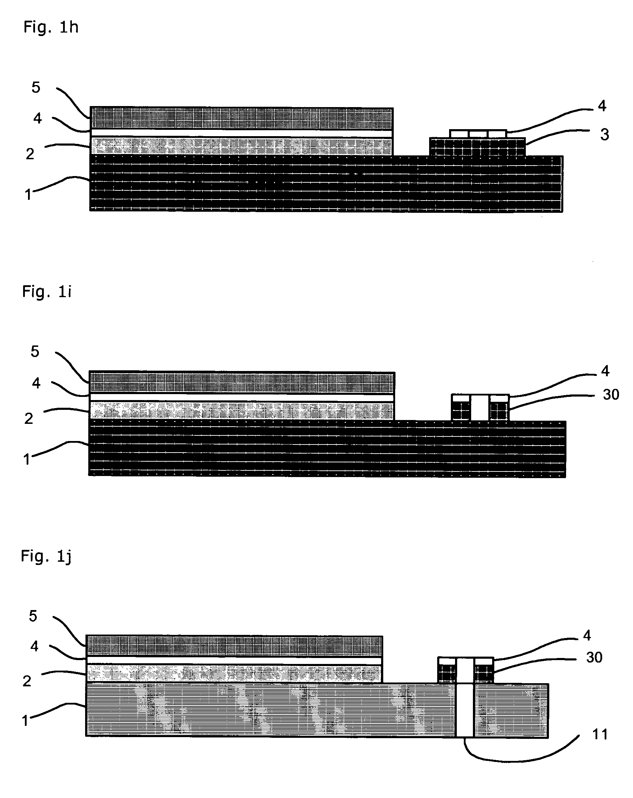

Die Mantelschicht 5 besteht aus dem gleichen Polymer wie die Unterschicht 2 oder aus einem dritten Polymer, das durch Belichten mit UV Licht ausgehärtet werden kann. Der Verfahrenschritt E wird im Prinzip mit den gleichen Teilschritten wie die Teilschritte 2 und 3 beim Verfahrenschritt B durchgeführt. Für die Strukturierung der Mantelschicht 5 wird eine dritte Belichtungsmaske 8c verwendet, die an den Fiducials auf dem Substrat 1 ausgerichtet wird. Die Belichtungsmaske 8c ist im Gebiet der nicht-transparenten Flächen 3 undurchlässig, so dass sich auf den nicht-transparenten Flächen 3 nach der Belichtung mit UV Licht durch die Belichtungsmaske 8c hindurch eine strukturierte, ausgehärtete Schicht aus dem Material der Kernschicht 4 bzw. aus Fotolack 10 und darüber eine unstrukturierte, nicht ausgehärtete Schicht aus dem Material der Mantelschicht 5 befindet. Dieser Zustand ist in der Fig. 1g dargestellt. Beim anschliessenden Entfernen des nicht belichteten Materials entstehen Öffnungen im Material der Kernschicht 4 bzw. Fotolack 10, d.h. es bleiben auf den nicht-transparenten Flächen 3 strukturierte Gebiete aus dem Material der Kernschicht 4 bzw. aus Fotolack 10 zurück. Dieser Zustand ist in der Fig. 1h dargestellt.

Der nächste Verfahrenschritt F dient dazu, die unsichtbaren Strukturen aus Material der Kernschicht 4 bzw. aus Fotolack 10, die sich auf den nicht-transparenten Flächen 3 befinden und die die tatsächliche Ist-Lage der Lichtwellenleiterstrukturen charakterisieren, in sichtbare Strukturen umzuwandeln, die verwendet werden können, um die elektro-optischen Bauteile bei der späteren Montage ohne Justierungsschritte auf dem Substrat 1 ausrichten und befestigen zu können.
F) Übertragen der durch die strukturierten Gebiete aus der Kernschicht 4 bzw. gegebenenfalls aus Fotolack auf den Flächen 3 gebildeten Strukturen in die nicht-transparenten Flächen 3.

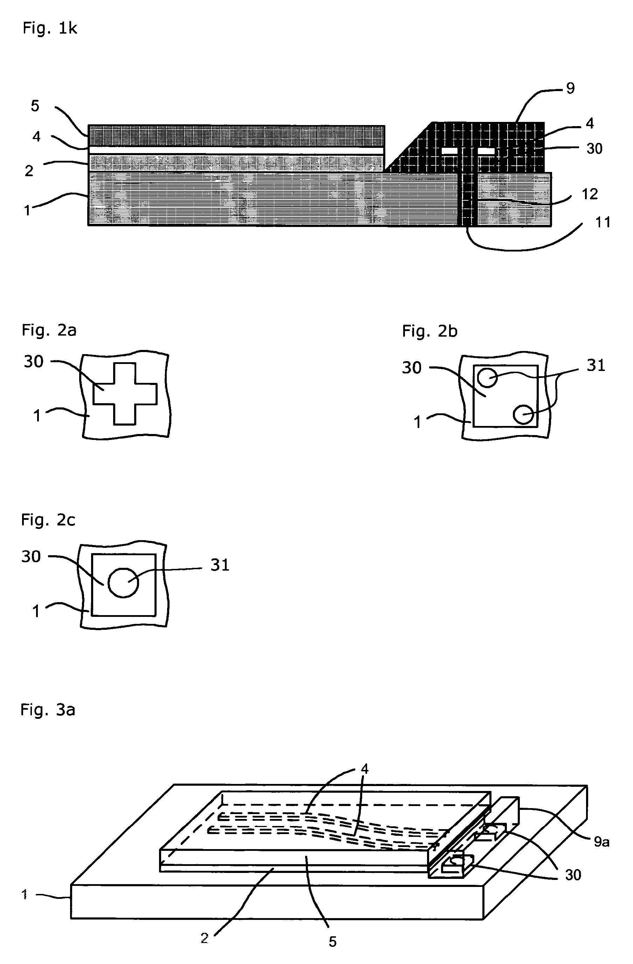

Da die nicht-transparenten Flächen 3 aus einem optisch gut sichtbaren Material, insbesondere aus Metall, bestehen, werden die strukturierten Gebiete aus der Kernschicht 4 bzw. gegebenenfalls aus dem Fotolack durch Entfernen von Material aus den nicht-transparenten Flächen 3 innerhalb der strukturierten Gebiete in die nicht-transparenten Flächen 3 übertragen, bevorzugt durch einen Ätzprozess, wobei die strukturierten Gebiete aus der Kernschicht 4 bzw. gegebenenfalls aus dem Fotolack 10 als Ätzmaske dienen. D.h. die Strukturen der strukturierten Gebiete definieren, welche Anteile der nicht-transparenten Flächen 3 entfernt werden. Die Fig. 1i zeigt die Leiterplatte nach diesem Schritt. Die nicht-transparenten Flächen sind nun strukturierte Flächen, d.h. sie bilden Referenzmarken 30. Die Fig. 2a bis 2c zeigen in Aufsicht bevorzugte Beispiele von Referenzmarken 30.

Die Enden der unsichtbaren Schichten (Unterschicht 2, Kernschicht 4, Mantelschicht 5) der Lichtwellenleiterstruktur und die sichtbaren Referenzmarken 30 sind hochpräzise zueinander positioniert. Die Genauigkeit ist nur von der verwendeten zweiten Belichtungsmaske 8b abhängig und liegt im Bereich von wenigen 10nm.

Die Reihenfolge der Verfahrenschritte F und E kann auch vertauscht werden.

Es ist möglich, weitere optische oder elektrische Schichten auf die drei Schichten (Unterschicht 2, Kernschicht 4 und Mantelschicht 5) der Lichtwellenleiterstrukturen aufzubringen, beispielsweise durch Auflaminieren mittels Verpressung.

Die Leiterplatte kann nun verwendet werden, d.h. es können die vorgesehenen elektronischen und elektro-optischen Komponenten montiert werden, wobei die Referenzmarken 30 vom Montageautomaten verwendet werden, um die elektro-optischen Komponenten auszurichten.

Elektro-optische Komponenten können Positionierungsstifte enthalten, die bei der Montage in entsprechende Löcher in der Leiterplatte gesteckt werden. Die Referenzmarken 30 werden nun benutzt, um solche Komponenten ohne weitere Justierung montieren zu können. Dazu dient der Verfahrenschritt G.
G) Herstellen von Löchern 11 oder Vertiefungen im Substrat 1, wobei die Referenzmarken 30 benutzt werden, um die Lage der Löcher 11 bzw. Vertiefungen zu definieren. Die Löcher 11 gehen vollständig durch das Substrat 1 hindurch, Vertiefungen nicht.

Die Löcher 11 werden entweder mittels eines mechanischen Werkzeugs wie Bohrer oder Fräser oder mittels eines Lasers in das Substrat 1 eingebracht. Die Ausrichtung und Steuerung des Werkzeugs bzw. Lasers erfolgt dabei mittels der Referenzmarken 30. Im Falle eines Lasers können die Referenzmarken 30 als Blenden benutzt werden, womit die Präzision zusätzlich erhöht wird.

Die Form der Löcher 11 ist nicht auf eine runde Form beschränkt, die Bearbeitung des Substrats 1 mittels eines Fräsers oder Lasers ermöglicht beliebige Formen, insbesondere Kreuze und Schlitze.

Es sind dabei mindestens die folgenden beiden Varianten möglich, die einzeln oder in Kombination zum Einsatz gelangen können:
G1) Es ist für jeden Positionierungsstift einer jeden elektro-optischen Komponente, die auf der Leiterplatte zu montieren ist, an der entsprechenden Stelle ein Loch 31 in einer Referenzmarke 30 vorhanden. Die in der Fig. 2b gezeigte Referenzmarke 30 enthält zwei Löcher 31, die in der Fig. 2c gezeigte Referenzmarke 30 enthält ein einziges Loch 31. Diese Löcher 31 werden nun im Verfahrenschritt G in durch das Substrat 1 hindurch gehende Löcher 11 umgewandelt. Die Fig. 1j zeigt die Leiterplatte nach diesem Schritt.
G2) Die für die Aufnahme der Positionierungsstifte nötigen Löcher 11 werden an anderen Stellen in das Substrat 1 eingebracht, die sich an anderen Stellen als die Referenzmarken 30 befinden, beispielsweise wenn eine elektro-optische Komponente an eine andere Metallisierungsebene anzuschliessen ist.

Die Fig. 1k zeigt ein Beispiel einer Leiterplatte, bei der eine elektro-optische Komponente 9 mit integrierten Positionierungsstiften 12 montiert ist. Die elektro-optische Komponente 9 ist in Bezug auf die Kernschicht 4 der Lichtwellenleiterstruktur hochpräzise positioniert und fixiert, wobei eine formschlüssige Verbindung der elektro-optischen Komponenten 9 mit der elektro-optischen Leiterplatte möglich ist. Die elektro-optische Komponente 9 ist beispielsweise ein Spiegelmodul oder ein elektro-optischer Wandler oder ein opto-elektrischer Wandler. Beispiele solcher Wandler sind LED's, Laserdioden, Photodioden.

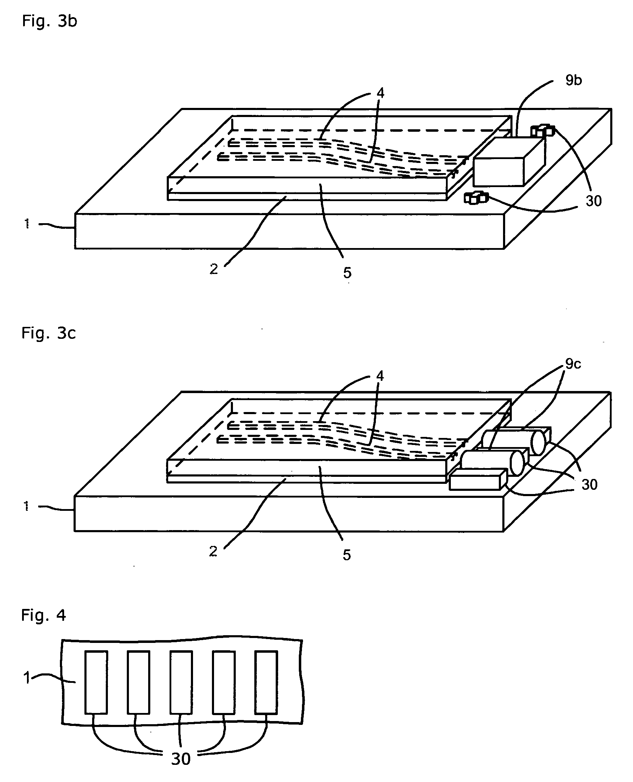

Die Fig. 3a zeigt eine perspektivische Ansicht einer elektro-optischen Leiterplatte mit einer Lichtwellenleiterstruktur, die mit einem Spiegelmodul 9a gekoppelt ist.

Die für die Aufnahme der Positionierungsstifte des Spiegelmoduls 9a nötigen Löcher 11 gehen durch die Referenzmarken 30 hindurch.

Die Fig. 3b zeigt eine perspektivische Ansicht einer elektro-optischen Leiterplatte mit einer Lichtwellenleiterstruktur, die mit einem elektro-optischen oder optoelektrischen Wandler 9b gekoppelt ist. Der Wandler 9b wurde bei der Montage anhand von neben seinem Platz angeordneten Referenzmarken 30 ausgerichtet und fixiert.

Da die sichtbaren Referenzmarken 30 die Lage der unsichtbaren Lichtwellenleiterstruktur charakterisieren, ist es für die genaue Justage der elektro-optischen Komponenten 9 nicht nötig, die Position der Lichtwellenleiterstruktur zu detektieren. Wenn die elektro-optischen Komponenten 9 wie beschrieben mittels der Referenzmarken 30 auf der Leiterplatte positioniert werden, sind sie automatisch in Bezug auf die Kernschicht 4 der Lichtwellenleiterstruktur richtig ausgerichtet.

Die Positionierung gewisser elektro-optischer Komponenten 9 kann auch relativ zu nicht-transparenten, unstrukturierten Flächen 3 erfolgen, welche gar nicht oder nur teilweise von einer Kernschicht 4 bedeckt sind, nämlich dann, wenn die Positionierungsgenauigkeit trotzdem ausreicht.

Oftmals ist es nötig, optische Signale aus Glasfasern in Lichtwellenstrukturen in der elektro-optischen Leiterplatte einzukoppeln. Die Fig. 4 zeigt eine mögliche Lösung für dieses Problem. Eine Referenzmarke 30 ist so ausgestaltet, dass die mit den Verfahrensschritten C1 (oder C2) und D hergestellten Strukturen Zwischenräume sind, in welche die Glasfasern 9c einlegbar sind. Dies ist insbesondere dann möglich, wenn die Schichtdicke der Metallschicht genügend gross ist, so dass die Zwischenräume die Position der Glasfasern 9c auf mechanische Weise definieren. Glasfasern 9c haben typischerweise einen Durchmesser von etwa 150 µm. Wenn die Dicke der Metallschicht etwa halb so gross ist wie der Durchmesser der Glasfasern 9c, dann reicht dies für deren genaue Positionierung in der Regel aus. Die Zwischenräume der Referenzmarke 30 können jedoch bei Bedarf mittels mechanischer Bearbeitung oder mittels Laserbearbeitung zu Nuten im Substrat 1 vertieft werden. Alternativ können die Referenzmarken 30 verwendet werden, um Nuten positionsgenau in das Substrat 1 zu fräsen. Die Referenzmarken 30 dienen dabei zur Ausrichtung der Bearbeitungsmaschine bzw. als Blenden für den Laserstrahl. Aufgrund der präzisen Ausrichtung der Zwischenräume der Referenzmarken 30 bzw. der Nuten relativ zur Kernschicht 4 der Lichtwellenleiterstruktur ist eine präzise Positionierung der Glasfasern 9c relativ zur Kernschicht 4 automatisch gegeben. Die Glasfasern 9c müssen damit bei der Montage nicht aufwendig justiert werden.

Die elektro-optischen Leiterplatten können hochkomplexe optische Strukturen enthalten, mit einer sehr grossen Anzahl an Lichtwellenleiterstrukturen. Auf den elektro-optischen Leiterplatten mit Lichtwellenleiterstrukturen können weitere Leiterplatten aufgebaut werden, so dass die optischen Lichtwellenleiterstrukturen Innenlagen zwischen Leiterplatten bilden.

Alternativ zu flüssigen, mit UV Licht aushärtbaren Polymeren können polymere Trockenfilm-Materialien verwendet werden.

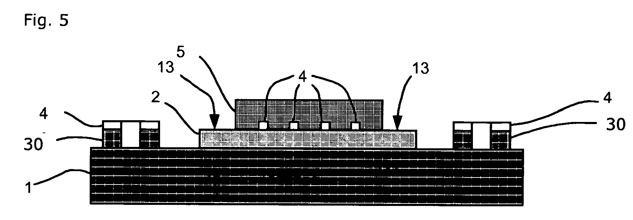

Die Schichtdicken der Unterschicht 2, der Kernschicht 4 und der Mantelschicht 5 können mit einer Präzision von einigen wenigen µm erzeugt werden. Diese Präzision reicht in vielen Fällen aus, um die Lichtwellenleiterstrukturen und die elektro-optischen Komponenten 9 auch in Bezug auf die Höhe mit der erforderlichen Genauigkeit auszurichten. Falls eine höhere Präzision verlangt ist, wird die obere Mantelschicht 5 so belichtet, dass beim nachfolgenden Waschschritt die Unterschicht 2 teilweise an definierten Aussparungsstellen 13 freigelegt wird. Dieser Zustand ist in der Fig. 5 gezeigt. Diese Aussparungsstellen 13 definieren die Höhe der Kernschicht 4 und somit die Lage der das Licht leitenden Teile der Lichtwellenleiterstrukturen. Elektro-optische Komponenten 9, die entsprechend ausgebildet sind, können auf solchen Aussparungsstellen 13 zur Auflage gebracht werden, so dass auch eine präzise Ausrichtung in der Höhe ohne weitere Justage automatisch erfolgt.

## Patentansprüche

1. Verfahren zur Herstellung einer elektro-optischen Leiterplatte mit Lichtwellenleiterstrukturen, die aus einer optisch transparenten Unterschicht (2), einer transparenten Kernschicht (4) und einer Mantelschicht (5) bestehen, umfassend die Schritte:
- Bilden von nicht-transparenten Flächen (3) auf dem Substrat (1), die aus einem nicht-transparenten Material bestehen,
- Aufbringen der Unterschicht (2) auf das Substrat (1) und Strukturieren der Unterschicht (2) derart, dass die Unterschicht (2) die nicht-transparenten Flächen (3) nicht bedeckt,
- entweder Aufbringen der Kernschicht (4), wobei die Kernschicht (4) sowohl die Unterschicht (2) als auch die nicht-transparenten Flächen (3) bedeckt, oder Aufbringen der Kernschicht (4), wobei die Kernschicht (4) die nicht-transparenten Flächen (3) nicht bedeckt, und Aufbringen einer Schicht aus Fotolack (10), die die nicht-transparenten Flächen (3), nicht aber die Kernschicht (4) bedeckt,
- Strukturieren der Kernschicht (4) und gegebenenfalls der Schicht aus Fotolack (10) durch Belichten mit elektromagnetischer Strahlung durch eine einzige Belichtungsmaske (8b) hindurch und anschliessend Entfernen der nicht belichteten Teile der Kernschicht (4) und gegebenenfalls der nicht belichteten Teile der Schicht aus Fotolack (10), um belichtete Anteile der Kernschicht (4) auf der Unterschicht (2) als Teil der Lichtwellenleiterstrukturen zurückzulassen und um belichtete Anteile der Kernschicht (4) bzw. gegebenenfalls aus Fotolack auf den nicht-transparenten Flächen (3) zurückzulassen, die strukturierte Gebiete bilden,
- Aufbringen und Strukturieren der Mantelschicht (5) derart, dass die Mantelschicht (5) die nicht-transparenten Flächen (3) nicht bedeckt, und
- Entfernen von Material aus den nicht-transparenten Flächen (3) innerhalb der strukturierten Gebiete, um Referenzmarken (30) zu bilden.

2. Verfahren nach Anspruch 1, **dadurch gekennzeichnet, dass** das genannte Entfernen von Material durch Ätzen erfolgt, wobei die strukturierten Gebiete als Ätzmaske dienen.

3. Verfahren nach Anspruch 1 oder 2, **dadurch gekennzeichnet, dass** die nicht-transparenten Flächen (3) aus einem Metall, insbesondere Kupfer, bestehen.

4. Verfahren nach einem der Ansprüche 1 bis 3, umfassend den weiteren Schritt:
Benutzen der Referenzmarken (30) zum Anbringen von Löchern (11) oder Vertiefungen im Substrat (1).

5. Verfahren nach einem der Ansprüche 1 bis 4, **dadurch gekennzeichnet, dass** die Mantelschicht (5) so strukturiert wird, dass die Unterschicht (2) teilweise an definierten Aussparungsstellen (13) freigelegt wird.

## Claims

1. Method for producing an electro-optical printed circuit board with optical waveguide structures which consist of an optically transparent bottom layer (2), a transparent core layer (4) and a transparent cladding layer (5), comprising the steps of:
- forming optically non-transparent areas (3) on a substrate (1) which consist of a non-transparent material;
- applying the bottom layer (2) to the substrate (1) and structuring the bottom layer (2) in such a way that the bottom layer (2) does not cover the non-transparent areas (3);
- either applying the core layer (4), with the core layer (4) covering both the bottom layer (2) as well as the non-transparent areas (3), or applying the core layer (4), with the core layer (4) not covering the non-transparent areas (3), and applying a layer of photoresist (10) which covers the non-transparent areas (3) but not the core layer (4);
- structuring the core layer (4) and given the case the layer of photoresist (10) by exposure to electromagnetic radiation through a single exposure mask (8b) and subsequently removing the non-exposed parts of the core layer (4) and given the case the non-exposed parts of the layer of photoresist (10), in order to leave structured regions of the core layer (4) on the bottom layer (2) as part of the optical waveguide structures and in order to leave exposed parts of the core layer (4) or given the case of photoresist on the non-transparent areas (3) which form structured areas;
- applying and structuring the cladding layer (5) in such a way that the cladding layer (5) does not cover the non-transparent areas (3), and
- removing of material from the non-transparent areas within the structured areas in order to form reference marks (30).

2. Method according to claim 1, **characterized in that** said removing of material occurs by etching, with the structured areas being used as etching mask.

3. Method according to claim 1 or 2, **characterized in that** the non-transparent areas (3) consist of a metal, especially copper.

4. Method according to any of claims 1 to 3, comprising the further step:
using the reference marks (30) for applying holes (11) or recesses in the substrate (1).

5. Method according to any of claims 1 to 4, **characterized in that** the cladding layer (5) is structured in such a way that the bottom layer (2) is partly uncovered at defined exposure areas (13).

## Revendications

1. Procédé de fabrication d'un circuit imprimé optique électrique avec des structures de guides d'ondes optiques composées d'une couche de fond (2) optiquement transparente, d'une couche d'âme transparente (4) et d'une couche d'enveloppe (5), comprenant les étapes suivantes:
- formation de surfaces non transparentes (3) sur le substrat (1), fabriquées en matériau non transparent,
- application de la couche de fond (2) sur le substrat (1) et structuration de la couche de fond (2) de telle sorte que la couche de fond (2) ne couvre pas les surfaces non transparentes (3),
- soit application de la couche d'âme (4) de sorte que la couche d'âme (4) couvre la couche de fond (2) et les surfaces non transparentes (3), soit application de la couche d'âme (4) de sorte que la couche d'âme (4) ne couvre pas les surfaces non transparentes (3) et application d'une couche en résine photosensible (10) qui couvre les surfaces non transparentes (3) mais pas la couche d'âme (4),
- structuration de la couche d'âme (4) et le cas échéant de la couche en résine photosensible (10) par exposition à un rayonnement électromagnétique à travers un seul masque d'exposition (8b), puis enlèvement des parties non exposées de la couche d'âme (4) et le cas échéant des parties non exposées de la couche de résine photosensible (10) pour laisser des parties exposées de la couche d'âme (4) sur la couche de fond (2) qui constituent des parties des structures de guides d'ondes optiques et pour laisser des parties exposées de la couche d'âme (4) ou le cas échéant de la couche en résine photosensible sur les surfaces non transparentes (3) qui forment des zones structurées,
- application et structuration de la couche d'enveloppe (5) de telle sorte que la couche d'enveloppe (5) ne couvre pas les surfaces non transparentes (3), et
- enlèvement du matériau des surfaces non transparentes (3) dans les zones structurées pour former des marques de référence (30).

2. Procédé selon la revendication 1, **caractérisé en ce que** ledit enlèvement du matériau susmentionné est effectué par gravure, les zones structurées étant utilisées comme masque de gravure.

3. Procédé selon la revendication 1 ou 2, **caractérisé en ce que** les surfaces non transparentes (3) sont en métal, tout particulièrement en cuivre.

4. Procédé selon l'une des revendications 1 à 3 comprenant en outre l'étape suivante:
utilisation des marques de référence (30) pour la réalisation de trous (11) ou de cavités dans le substrat (1).

5. Procédé selon l'une des revendication 1 à 4, **caractérisé en ce que** la couche d'enveloppe (5) est structurée de telle sorte que la couche de fond (2) est en partie dégagée sur des zones d'évidement (13) définies.
